Europäisches Patentamt

(19) European Patent Office

Office européen des brevets

(11) Numéro de publication: **0 185 426**
**B1**

(12) **FASCICULE DE BREVET EUROPEEN**

(51) Int. Cl.⁴: **H 01 L 27/02, H 01 L 29/72**

(45) Date de publication du fascicule du brevet:
**06.09.89**

(21) Numéro de dépôt: **85202038.7**

(22) Date de dépôt: **10.12.85**

(54) **Circuit intégré comprenant un dispositif de protection contre les décharges électrostatiques.**

(30) Priorité: **21.12.84 FR 8419656**

(43) Date de publication de la demande:
**25.06.86 Bulletin 86/26**

(45) Mention de la délivrance du brevet:
**06.09.89 Bulletin 89/36**

(84) Etats contractants désignés:
**DE FR GB IT NL**

(56) Documents cités:
**EP-A- 0 057 024**
**FR-A- 2 494 501**

**IBM TECHNICAL DISCLOSURE BULLETIN, vol. 23, no. 2, juillet 1980, pages 594-595, New York, US; D.C. BANKER et al.: "Lateral NPN protect device"**
**IEEE TRANSACTIONS ON NUCLEAR SCIENCE, vol. NS-2, no. 6, décembre 1981, pages 4295-4301, New York, US; R.L. PEASE: "Latchup in bipolar LSI devices"**

(73) Titulaire: **RTC-COMPELEC, 130, Avenue Ledru-Rollin, F-75011 Paris (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB IT NL**

(72) Inventeur: **Chapron, Claude, SOCIETE CIVILE S.P.I.D. 209 rue de l'Université, F-75007 Paris (FR)**

(74) Mandataire: **Jacquard, Philippe et al, SOCIETE CIVILE S.P.I.D. 209, rue de l'Université, F-75007 Paris (FR)**

ACTORUM AG

## Description

La présente invention concerne un circuit intégré présentant un corps semi-conducteur et comprenant un dispositif de protection contre les décharges électrostatiques, ledit corps semi-conducteur présentant une région de substrat d'un premier type de conductivité, ledit dispositif de protection présentant une première et une deuxième région active d'un second type de conductivité espacées latéralement et jouxtant ladite région de substrat, la première région active étant connectée à une première couche conductrice à protéger, la deuxième région active étant connectée à une seconde couche conductrice en vue de sa connexion à une source de tension de référence, les première et deuxième régions actives étant séparées par une troisième région active constituée par une portion de ladite région de substrat, une première couche isolante épaisse qui est incluse au moins sur une partie de son épaisseur dans le corps semi-conducteur et une deuxième couche isolante mince étant présentes, ladite première couche isolante s'étendant jusqu'à une première profondeur et recouvrant ladite troisième région active entre lesdites première et deuxième régions actives espacées latéralement.

Un tel circuit est connu du brevet européen n° 57 024 (N.V. Philips). Dans celui-ci, les première et deuxième régions actives sont réalisées entre des régions d'oxyde épais et ne sont recouvertes que par des régions d'oxyde mince à travers lesquelles ont été réalisées des fenêtres de contact électrique. Or, ces régions d'oxyde mince ne supportent pas de différences de potentiel importantes, notamment celles correspondant à des décharges électrostatiques.

Il en résulte que le dispositif de protection qui par définition est susceptible de recevoir des différences de potentiel importantes n'est pas suffisamment isolé électriquement de la surface du circuit.

Les régions d'oxyde mince recouvrant les première et deuxième régions actives sont faibles au point de vue isolation électrique. Par exemple, il est absolument impossible de recouvrir une région d'oxyde mince par une métallisation autre que celle de prise de contact de la région active qu'elle recouvre.

La présente invention a pour objet un circuit intégré ne présentant pas ces inconvénients. Dans celui-ci, les trois régions actives constituant le dispositif de protection ne sont en effet recouvertes à aucun endroit par un oxyde mince. Dans ce cas, le dispositif de protection est complètement isolé du point de vue électrique par rapport à la surface du circuit et aucune détérioration de l'oxyde n'est à craindre en cas de décharge électrostatique.

Dans ce but, le circuit intégré selon l'invention est caractérisé en ce que les première et deuxième régions actives sont disposées à une profondeur plus grande que ladite première profondeur, et présentent chacune une première et une deuxième portion, chacune des premières portions desdites première et deuxième régions actives étant recouvertes par respectivement une première et une deuxième région de contact du deuxième type de conductivité, lesdites première et deuxième région de contact étant recouvertes respectivement par lesdites première et deuxième couches conductrices, et les deuxièmes portions de première et deuxième régions actives étant recouvertes par ladite première couche isolante épaisse.

La région de substrat peut être plus faiblement dopée que les première et deuxième régions actives, ce qui permet de minimiser la valeur des capacités parasites.

Les première et deuxième régions de contact peuvent avantageusement faire partie d'une couche épitaxiale du second type de conductivité.

Selon une variante, le dispositif jouxte une plage de métallisation de l'entrée à protéger. Dans ce but, la deuxième région active entoure complètement la première région active, la deuxième région de contact recouvre la deuxième région active à l'exception d'une région formant un pont isolant et la première couche conductrice présente une première bande de contact traversant le pont isolant de manière à réaliser une connexion avec un circuit d'entrée à protéger.

Selon une autre variante, la première couche conductrice est constituée par une première plage de métallisation, la deuxième région active entoure la première région active, la deuxième région de contact recouvre la deuxième région active à l'exception d'une région formant un deuxième pont isolant et la première couche conductrice présente une deuxième bande de contact traversant le deuxième pont isolant de manière à réaliser une connexion avec un circuit d'entrée à protéger.

Pour l'une ou l'autre de ces variantes, la deuxième couche conductrice peut présenter une troisième bande de contact disposée de manière à réaliser ladite connexion à une source de tension de référence. De préférence, les première et seconde couches conductrices recouvrent entièrement respectivement les première et seconde régions de contact.

Selon une variante préférée, le dispositif est en majeure partie situé en dessous d'une plage de métallisation correspondant à l'entrée à protéger, ce qui permet d'obtenir le double avantage supplémentaire, d'une part, d'un gain de place et d'autre part d'une diminution de la capacité parasite par substitution de la capacité de la plage.

Dans ce but, la première couche isolante épaisse est constituée par une portion de couche isolante qui recouvre la majeure partie de la surface des régions actives, et qui est elle-même recouverte par une deuxième plage de métallisation à l'exception d'une région jouxtant la deuxième couche conductrice, et ladite deuxième plage de métallisation comporte une partie constituant ladite première couche conductrice, de manière à relier électriquement ladite plage à la première région active.

Selon un mode de réalisation de cette variante, les première et seconde couches conductrices sont disposées à l'opposé l'une de l'autre et les régions actives sont imbriquées.

Dans ce but, la première région active présente d'une part 2n-1 branches actives avec $n \geq 1$, et d'autre part une première liaison électrique, notamment une première bande active reliant entre elles pour $n>1$ une extrémité des 2n-1 branches et constituée pour $n=1$ par une extrémité de la branche de la première région active, et la deuxième région active présente d'une part 2n branches actives et d'autre part une deuxième liaison électrique, notamment une deuxième bande active reliant entre elles une extrémité des 2n branches, et les branches des première et deuxième régions actives sont imbriquées et les première et deuxième couches conductrices sont disposées respectivement au niveau des première et deuxième liaisons électriques de telle sorte que la première couche conductrice borde le reste de la deuxième plage de métallisation qui est ainsi disponible pour relier électriquement l'entrée à protéger.

D'autre part, on peut obtenir une répartition uniforme des courants en donnant aux branches extrêmes de la deuxième région active une largeur moitié de celle des branches de la première région active et des autres branches de la deuxième région active.

Pour $n=1$, la deuxième région active est en forme de U et ses branches ont avantageusement une largeur moitié de celle de la première région active.

Selon un deuxième mode de réalisation de cette variante, le dispositif inclut la résistance série habituellement insérée entre la plage de métallisation d'entrée et le circuit d'entrée correspondant.

Dans ce but, la première région active présente 2n-1 branches actives avec $n \geq 1$ et d'autre part une première liaison électrique, notamment une première bande active, reliant entre elles pour $n>1$ une extrémité desdites 2n-1 branches actives et constituée pour $n=1$ par une extrémité de la branche de la première région active, la deuxième région active présente 2n branches actives, les branches actives des première et deuxième régions actives sont imbriquées, les 2n branches actives de la deuxième région active sont reliées électriquement entre elles et au moins une branche active de la première région active se prolonge, du côté opposé à la première couche conductrice, de préférence en croisant ladite deuxième couche conductrice qui relie alors électriquement les 2n branches actives de la deuxième région active, et dont elle est alors isolée par ladite portion de couche isolante, par un prolongement enterré de même type de conductivité que la première région active et dont l'extrémité libre est reliée à un étage d'entrée de l'entrée à protéger par l'intermédiaire d'une couche de contact, ledit prolongement formant ainsi ladite résistance série.

L'invention sera mieux comprise à la lecture de la description qui va suivre, donnée à titre d'exemple non limitatif, en liaison avec les dessins qui représentent:
- les figures 1a et 1b, en vue de dessus, respectivement une première variante du dispositif selon l'invention, et un détail de celui-ci;
- la figure 2, une coupe verticale AA de la figure 1b;
- la figure 3, une vue de dessus de la figure 2, avec enlèvement des métallisations.
- les figures 4a et 4b, en vue de dessus, un mode préféré de réalisation du dispositif selon l'invention et un détail de celui-ci;
- les figures 5 et 6, respectivement les coupes verticales BB et CC de la figure 4b;
- la figure 7, une variante de réalisation interdigitée dudit mode préféré;
- les figures 8a et 8b respectivement en vue de dessus et en coupe verticale, une troisième variante de l'invention;
- les figures 9a et 9b respectivement en vue de dessus avec représentation en pointillés du contour des métallisations et en coupe verticale, un autre mode de réalisation de la deuxième variante et la fig. 10, un schéma électronique correspondant.
- la figure 11 une partie de circuit intégré épitaxié présentant un oxyde mince et un oxyde épais, en technique dite «SUBILO».

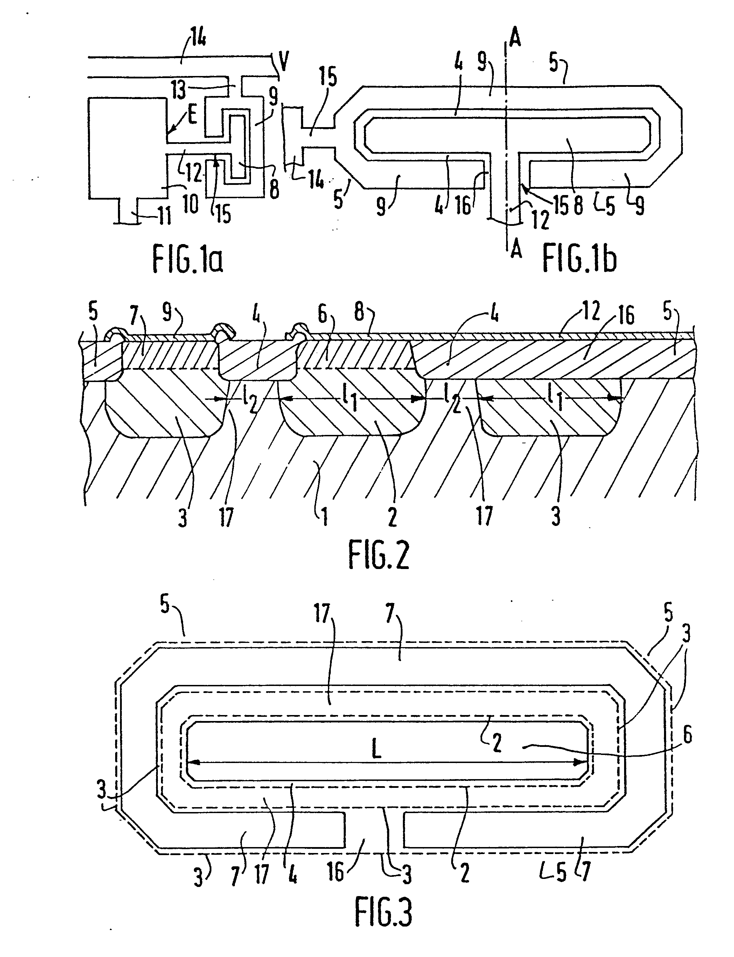

Selon les figures 1a et 1b, une entrée E à protéger présente une plage de métallisation 10 destinée à sa connexion électrique, une ligne 11 de liaison électrique, avec son étage d'entrée, et une bande de contact 12 formant contact avec une métallisation 8 en forme de bande. Une métallisation 9 entoure la métallisation 8 à l'exception d'un canal 15 laissant libre passage à la bande de contact 12. La métallisation 9 présente une patte 13 formant contact avec une ligne 14 alimentée à une tension de référence, à savoir une tension d'alimentation V du circuit ou la tension de masse.

Entre les métallisations 8 et 9, se trouve une couche d'isolation 4, par exemple en $S_iO_2$ connue en soi pour l'isolation latérale des composants, se prolongeant en 16 dans le canal 15. La métallisation 9 est avantageusement bordée sur son contour extérieur par une couche d'isolation 5 par exemple en $S_iO_2$ laquelle rejoint la région isolante 16.

Selon la figure 2, le circuit intégré présente un substrat 1, par exemple en Si, de préférence faiblement dopé d'un premier type de conductivité, par exemple p, et deux couches enterrées 2 et 3 du second type de conductivité opposé au premier donc n dans l'exemple et de préférence fortement dopées. Une couche 6 du second type de conductivité, généralement obtenue par épitaxie, est disposée sur la couche enterrée 2 de manière à former une région de contact dont le niveau de dopage n'est pas critique et assurant une continuité électrique entre la couche enterrée 2 et la métallisation 8 qui la recouvre. Une couche 7 du second type de conductivité, généralement également obtenue par la même épitaxie est disposée sur la couche enterrée 3 de manière à former une région de contact pour la métallisation 9 qui la recouvre. La couche d'isolation 4 qui entoure la métallisation 8 et la région de contact 6, et se prolonge en 16 dans la région du canal 15, est plus profonde que la couche 6, et délimite les bords supérieurs de la couche enterrée 2 et le bord supérieur interne de la couche enterrée 3. Les couches enterrées 2 et 3 sont séparées par des portions étroites 17 du substrat 1 avec lesquelles elles forment trois régions contigues de types de conductivité alternés qui sont actives pour la protection du circuit.

D'une manière générale, on appelle région de contact toute région contigüe à une région active enterrée et appropriée à réaliser un contact électrique avec une métallisation la recouvrant. On comprend que ce n'est qu'à titre d'exemple que l'on a décrit à ce titre une région supplémentaire obtenue par épitaxie. A titre de variante, la région de contact contigüe à une région active peut être constituée par une portion de la surface du substrat sur laquelle est disposée la métallisation.

La couche d'isolation 5, de même profondeur que la couche 4, délimite le bord supérieur externe de la couche enterrée 3, et forme un caisson d'isolement pour le dispositif de protection. Elle rejoint la portion 16 dans la région du canal 15. La couche d'isolation 5 fait en général partie, comme représenté, d'une couche d'oxyde profond existant en des endroits choisis.

Sur la figure 3, on a représenté en pointillé les bords des couches enterrées 2 et 3, lesquelles sont obtenues par diffusion à travers un masque avant la réalisation des couches isolantes 4 et 5, et s'étendent en dessous de celles-ci sur une certaine distance. L'espace entre les pointillés 2 et 3 correspond à la portion étroite 17 du substrat 1. La région isolante 16 ponte les régions 4 et 5 dans la région du canal 15, ce qui permet le passage de la patte conductrice 12.

A titre d'exemple, on a réalisé un dispositif de protection sur un substrat p⁻ de résistivité $10\Omega$ cm (dopage de l'ordre de $10^{16}$ atomes/cm³), les couches enterrées 2 et 3 de type n⁺ ayant une résistance de l'ordre de $30\Omega$ par carré. La profondeur des couches 4 et 5 dites d'oxyde profond selon une dénomination courante de la technique et qui sont en $SiO_2$ est de l'ordre de 1,5 micron, ce qui lui permet de résister à des différences de potentiel telles qu'on en trouve dans les décharges électrostatiques. La portion étroite 17 du substrat a une largeur $l_2$ de l'ordre de 5 microns et les couches enterrées 2 et 3, une largeur $l_1$ de l'ordre de 10 microns. La longueur L de la couche enterrée 2 en forme de bande est de l'ordre de 50 à 100 microns. Ce dispositif est à même d'assurer une protection vis à vis de tensions électrostatiques de l'ordre de quelques kV provenant de la décharge du corps humain.

D'une manière générale, les trois régions actives 2, 17 et 3 sont selon toute probabilité susceptibles de fonctionner comme un transistor bipolaire de faibles performances en gain et en mode d'avalanche, le fonctionnement dépendant des dimensions, des dopages et des polarités desdites zones actives. L'épaisseur de la couche 4 permet à la bande de contact 12 d'être isolée électriquement des régions actives 3 et 17 même lors d'une décharge électrostatique.

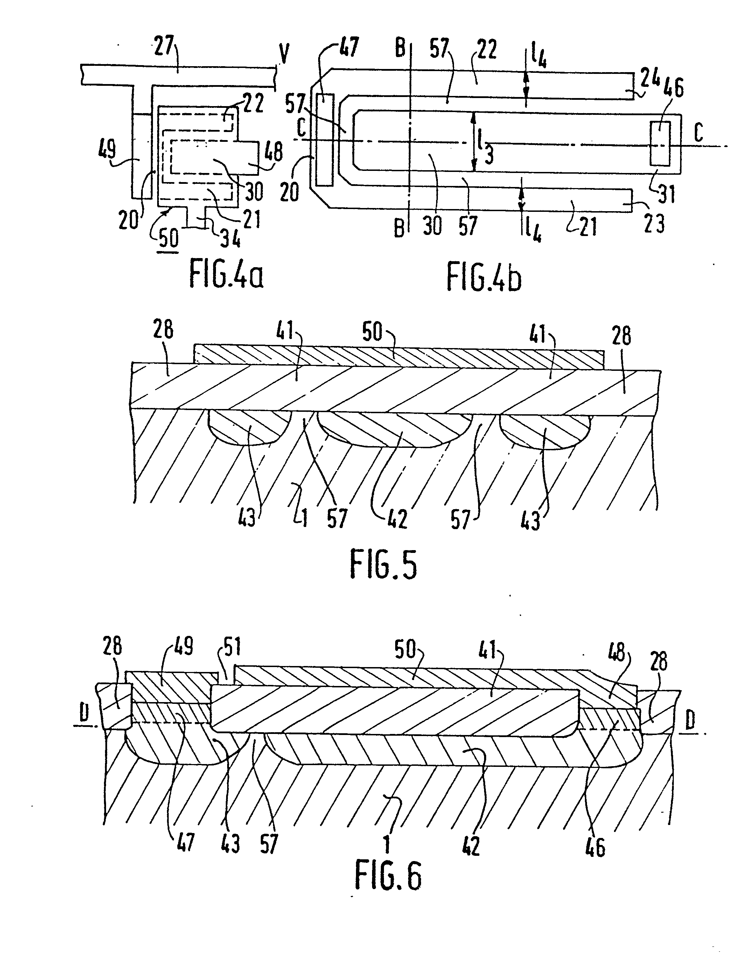

Selon les figures 4a, 4b et 5, le dispositif de protection est enterré presque en totalité sous la métallisation 50 de l'entrée à protéger dont elle est séparée par une portion 41 d'une couche d'isolation 28. Une première couche enterrée 42 du type de conductivité opposé à celui du substrat forme une bande 30 entourée par une deuxième couche enterrée 43 également du type de conductivité opposé à celui du substrat 1. Les première 42 et deuxième 43 couches enterrées qui constituent deux régions actives sont recouvertes par des couches de contact respectivement 46 et 47 de préférence épitaxiées, uniquement aux endroits utilisés pour les prises de contact. Entre les deux régions actives 42 et 43, une région 57 du substrat constitue la troisième région active. Il est bien entendu possible que la couche enterrée 43 entoure complètement la première couche enterrée 42. Cependant, selon la variante préférentielle représentée, la seconde couche enterrée 43 forme un U dont les branches 21 et 22 encadrent la bande 30 formant la première couche enterrée 42, l'extrémité 31 de celle-ci étant disponible pour la prise de contact 48 s'effectuant à travers une fenêtre de la couche d'isolation 28 entre la métallisation 50 et la couche de contact 46. De cette façon, la prise de contact 48 prolonge la plage principale de prise de contact d'entrée de la métallisation 50. La barre 20 qui relie les branches 21 et 22 du U est située au moins en partie à l'extérieur de la métallisation 50 de manière à recevoir une métallisation 49 reliant à travers une deuxième fenêtre de la couche d'isolation 28 la couche de contact 47 à une barre 27 d'alimentation en tension du circuit.

La couche isolante 28, par exemple en $SiO_2$, a une profondeur plus grande que celle des couches 46 et 47 de sorte qu'elle délimite les bords supérieurs de la couche enterrée 42 et de la couche enterrée 43 et forme un caisson d'isolation pour l'ensemble du dispositif de protection. Une portion étroite 57 du substrat est située entre les couches enterrées 42 et 43.

Pour obtenir une répartition uniforme des courants, on peut donner à la région active 42 une largeur $l_3$ égale à deux fois celle $l_4$ de la région active 43.

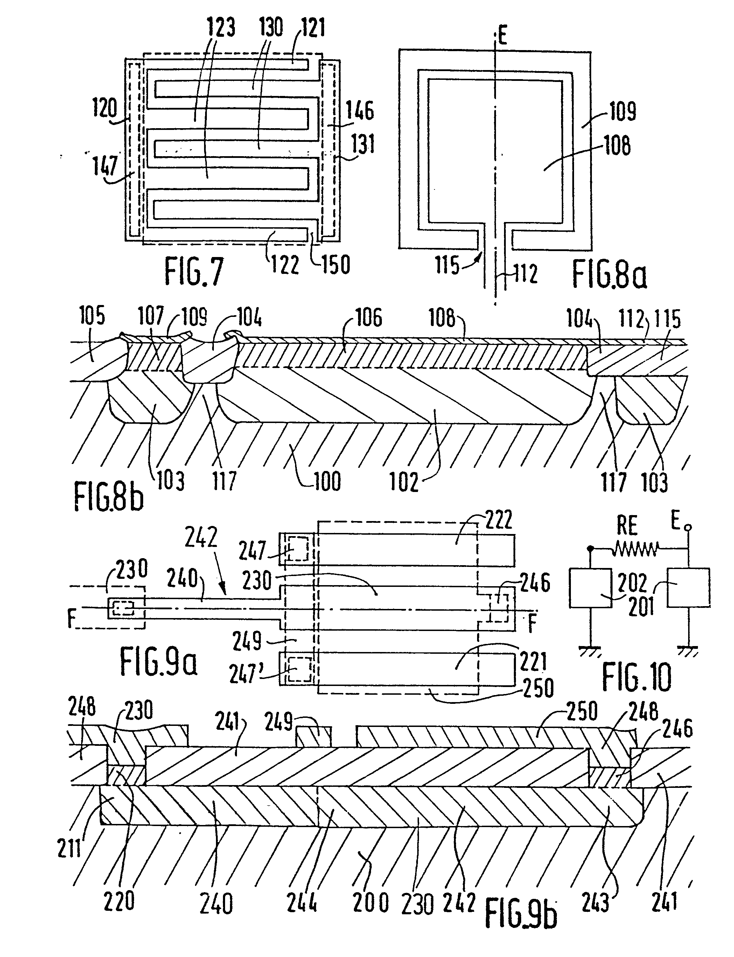

Selon la figure 6, la couche d'isolation 41 présente deux fenêtres, l'une étant disposée sur la barre du U pour recevoir la patte de métallisation 49, et l'autre au niveau de l'extrémité 31 de la bande 30 pour recevoir la patte de métallisation 48 bordant la plage de métallisation 50.

Comme dans le cas de la variante précédente, les régions actives, 42, 43 et 57, fonctionnent comme un transistor bipolaire en mode d'avalanche. La couche d'oxyde 41 a une épaisseur suffisante pour isoler la métallisation 50 des régions actives 43 et 57 notamment, même en cas de décharge électrostatique.

Selon la figure 7, la bande 30 des figures précédentes est remplacée par une pluralité de branches 130 reliées entre elles par une bande 131 de même constitution que les branches 130 et portant sur une majeure partie de sa longueur une couche de contact 146 (représentée en pointillés) revêtue d'une métallisation non représentée, prolongeant une plage de métallisation 150 (représentée en pointillés). Des branches 123 reliées par une bande 120 de même constitution que celles-ci, sont interdigitées avec les branches 130 et leurs branches extrêmes 121, 122, ont une largeur moitié de celles des autres branches 123 de manière à obtenir l'avantage d'une répartition uniforme des courants.

On remarquera que la liaison électrique entre les branches peut être réalisé par tout moyen, notamment seulement par une métallisation ou seulement par une bande de même constitution que les branches.

La troisième variante (figures 8a et 8b) s'apparente à la première variante, à ceci près que la dimension de la métallisation 108 est telle qu'elle constitue la plage de métallisation de l'entrée à protéger. Elle est reliée au circuit d'entrée correspondant par une patte 112 traversant un pont isolant 115. Selon la figure 8b, le dispositif comporte un substrat 100 faiblement dopé d'un premier type de conductivité et deux couches enterrées 102 et 103 du second type de conductivité opposé au premier. Une couche 106 du second type de conductivité, et généralement obtenue par épitaxie, est disposée sur la couche enterrée 102 de manière à former une région de contact assurant une continuité électrique entre la couche enterrée 102 et la plage de métallisation 108 qui la recouvre. De même, une couche 107 du second type de conductivité généralement obtenue par épitaxie, est disposée sur la couche enterrée 103 de manière à former une région de contact pour la métallisation 105 qui la recouvre. La couche d'isolation 104 qui entoure la métallisation 108 et la couche de contact 106 est plus profonde que la couche 106 et délimite les bords supérieurs de la couche enterrée 102 et le bord supérieur interne de la couche enterrée 103 qui entoure cette dernière. Les couches enterrées 102 et 103 sont séparées par des portions étroites 117 du substrat 100 avec lesquelles elles forment trois zones actives de conductivités alternées.

Les figures 9a et 9b se rapportent à un mode de réalisation voisin de la deuxième variante (fig. 4a et 4b), mais dans lequel la barre de la deuxième couche enterrée est supprimée ce qui fait que cette dernière se trouve réduite à deux branches 221 et 222, alors que la métallisation correspondante (49) est conservée (et est maintenant référencée 249).

La première couche enterrée 242 comporte une branche active 230 qui se prolonge du côté opposé à la métallisation 248 et en croisant la métallisation 249 par un prolongement enterré 240, située en dehors des régions actives où les deux couches enterrées sont en vis-à-vis, de manière à réaliser une résistance série $R_E$ (fig. 10) entre la plage de métallisation de l'entrée E et un circuit d'entrée 202 correspondant à l'entrée E, le dispositif de protection 201 étant pour sa part connecté entre la plage de métallisation et la masse, prise ici comme tension de référence.

Les branches 221 et 222 présentent deux couches de contact respectivement 247, 247' assurant la continuité électrique entre leurs couches enterrées et la métallisation 249 qui elle-même relie électriquement les couches de contact 247 et 247'. On notera que le croisement mentionné ci-dessus n'est qu'un mode préféré de réalisation. La liaison électrique entre les couches 247 et 247' peut également être obtenue par une métallisation contournant les couches enterrées ou bien encore par liaison directe de chacune des couches 247 et 247' à des bandes de masse.

Plus particulièrement à la figure 9b, une première couche 242 enterrée dans un substrat 200 comporte à une extrémité 243 une couche de contact 246 et à son autre extrémité 244 le prolongement enterré 240 en général de même profondeur que la couche enterrée 242. L'extrémité 211 du prolongement enterré 240 qui est opposée à la première couche enterrée 242 est surmontée par une couche de contact 220.

Une couche d'isolation 241 comporte 4 fenêtres recevant chacune une des couches de contact 220, 246, 247, 248. La couche de contact 246 est revêtue d'une patte 248 jouxtant une plage de métallisation d'entrée 250, laquelle recouvre les trois branches 221, 222, 230 des couches actives enterrées jusqu'à une distance de la bande de métallisation 249 suffisante pour assurer une isolation.

On comprendra que le dispositif ainsi décrit peut comporter un plus grand nombre de branches.

Les modes de réalisation que décrits ci-dessus conviennent plus particulièrement à la technique bipolaire dite «LOCOS» ou «SUBILO» décrite dans la demande de brevet français FR 1 549 386 de N.V. PHILIPS et son addition 2 081 017.

Selon cette technique, les couches enterrées sont diffusées dans un substrat, après quoi on réalise une couche épitaxiée sur laquelle on réalise par masquage un enlèvement de portions exposées de la couche épitaxiée. On fait croître un oxyde d'isolation dans les ouvertures ainsi ménagées et on métallise de manière classique, après avoir réalisé les composants du circuit intégré dans la couche épitaxiée.

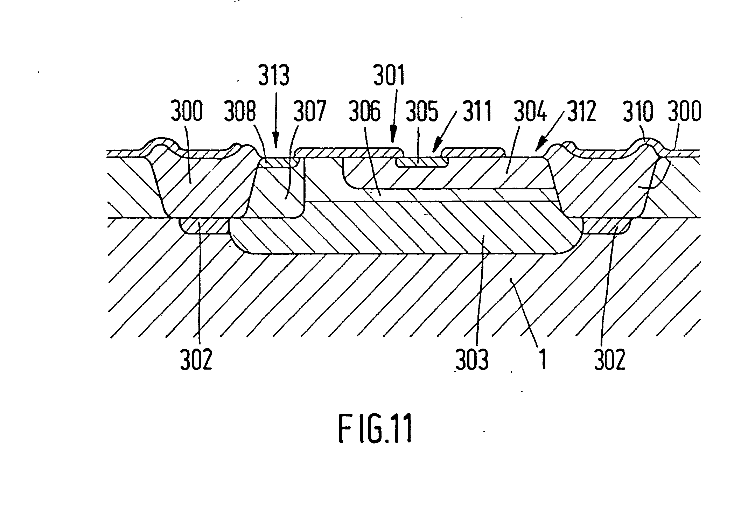

Selon la figure 11, un transistor réalisé selon la technique ci-dessus est représenté avant métallisation des contacts. Un substrat 1 qui peut être celui du circuit intégré selon l'invention est d'un premier type de conductivité, par exemple p. 11 comporte un anneau d'oxyde épais d'isolation latérale 300 d'épaisseur environ 1,5 micron qui définit un caisson isolant 301 dans lequel est réalisé le transistor. Le fond du caisson isolant 301 est constitué par une couche enterrée 303 très dopée du deuxième type de conductivité, par exemple n+.

Avant la réalisation de l'oxyde épais 300, ont été réalisées des régions très dopées 302 du premier type de conductivité dont la fonction est de minimiser les courants de fuite entre caissons. On notera que de telles régions, bien que non représentées aux figures précédentes, peuvent néanmoins être présentes sur le pourtour du dispositif de protection pour réaliser la même fonction.

Le transistor est réalisé dans une couche épitaxiale du deuxième type de conductivité. Sa région de collecteur 306 est constituée par la partie subsistante de celle-ci après implantation de la base 304 (du premier type), de l'émetteur 305 (du second type) et de régions 307 et 308 (du second type) servant à la prise de contact de collecteur. Une couche isolante mince 310 (d'épaisseur environ 0,1 micron) est disposée sur la couche épitaxiale et l'oxyde épais d'isolation latérale 300 et présente des fenêtres 311, 312 et 313 respectivement de prise de contact d'émetteur, de base et de collecteur.

L'invention ne se limite pas au cas des circuits intégrés bipolaires. En technologie MOS, la couche isolante épaisse peut être constituée par un oxyde de champ d'épaisseur adéquate.

## Revendications

1. Circuit intégré présentant un corps semiconducteur et comprenant un dispositif de protection contre les décharges électrostatiques, ledit corps semi-conducteur présentant une région de substrat d'un premier type de conductivité, ledit dispositif de protection présentant une première et une deuxième région active d'un second type de conductivité espacées latéralement et jouxtant ladite région de substrat, la première région active étant connectée à une première couche conductrice à protéger, la deuxième région active étant connectée à une seconde couche conductrice en vue de sa connexion à une source de tension de référence, les première et deuxième régions actives étant séparées par une troisième région active constituée par une portion de ladite région de substrat, une première couche isolante épaisse qui est incluse au moins sur une partie de son épaisseur dans le corps semi-conducteur et une deuxième couche isolante mince étant présentes, ladite première couche isolante s'étendant jusqu'à une première profondeur et recouvrant ladite troisième région active entre lesdites première et deuxième régions active espacées latéralement, caractérisé en ce que les première et deuxième régions actives sont disposées à une profondeur plus grande que ladite première profondeur, et présentent chacune une première et deuxième portion, chacune des premières portions desdites première et deuxième régions actives étant recouvertes par respectivement une première et une deuxième région de contact du deuxième type de conductivité, lesdites première et deuxième régions de contact étant recouvertes respectivement par lesdites première et deuxième couches conductrices, et les deuxièmes portions des première et deuxième régions actives étant recouvertes par ladite première couche isolante épaisse.

2. Circuit intégré selon la revendication 1, caractérisé en ce que la région de substrat est plus faiblement dopée que les première et troisième régions actives.

3. Circuit intégré selon une des revendications 1 ou 2, caractérisé en ce que les première et deuxième régions de contact font partie d'une couche épitaxiale du second type de conductivité.

4. Circuit intégré selon une des revendications 1 à 3 caractérisé en ce que la deuxième région active entoure complètement la première région active, en ce que la deuxième région de contact entoure la deuxième région active à l'exception d'une région formant un pont isolant et en ce que la première couche conductrice présente une première bande de contact traversant le pont isolant ainsi formé de manière à réaliser une connexion avec un circuit d'entrée à protéger.

5. Circuit intégré selon une des revendications 1 à 3 caractérisé en ce que la première couche conductrice est constituée par une première plage de métallisation, en ce que la deuxième région active entoure le pourtour de la première région active en ce que la deuxième région de contact recouvre la deuxième pont isolant et en ce que la première couche conductrice présente une deuxième bande de contact traversant le deuxième pont isolant de manière à réaliser une connexion avec un circuit d'entrée à protéger.

6. Circuit intégré selon une des revendications 4 ou 5 caractérisé en ce que la deuxième couche conductrice présente une troisième bande de contact disposée de manière à réaliser ladite connexion à une source de tension de référence.

7. Circuit intégré selon une des revendications 1 à 3 caractérisé en ce que la première couche isolante épaisse est constituée par une portion de couche isolante qui recouvre la majeure partie de la surface des régions actives et qui est elle même recouverte par une deuxième plage de métallisation, à l'exception d'une région jouxtant la deuxième couche conductrice et en ce que ladite deuxième plage de métallisation comporte une partie constituant la première couche conductrice, de manière à relier électriquement ladite plage à la première région active.

8. Circuit intégré selon la revendication 7, caractérisé en ce que la première région active présente d'une part 2n-1 branches actives avec n≧1, et d'autre part une première liaison électrique reliant entre elles pour n>1 une extrémité desdites 2n-1 branches actives, et constituée pour n=1 par une extrémité de la branche de la première région active, en ce que la deuxième région active présente d'une part 2n branches actives et d'autre part une deuxième liaison électrique reliant entre elles une extrémité des 2n branches actives, en ce que les branches actives des première et deuxième régions actives sont imbriquées, et en ce que les premières et deuxième liaisons électriques comportent les première et deuxième couches conductrices de telle sorte que la première couche conductrice borde le reste de la deuxième plage de métallisation.

9. Circuit intégré selon la revendication 8 caractérisé en ce que n=1 et en ce que la deuxième région active a la forme d'un U dont les branches encadrent la première région active, et en ce que la largeur des branches de la deuxième région active est moitié de celle de la première région active.

10. Circuit intégré selon la revendication 8 caractérisé en ce que n>1 et en ce que les branches actives externes de la première région active ont une largeur moitié de celle de ses autres branches actives et de celles de la deuxième région active.

11. Circuit intégré selon la revendication 7 caractérisé en ce que la première région active présente d'une part 2n-1 branches actives avec n≧1 et d'autre part une première liaison électrique reliant entre elles pour n>1 une extrémité desdites 2n-1 branches actives et constituée pour n=1 par une extrémité de la branche de la première région active, en ce que la deuxième région active présente 2n branches actives, les branches actives des première et deuxième régions actives étant imbriquées, en ce que les 2n branches actives de la deuxième région active sont reliées électriquement entre elles par ladite deuxième couche conductrice et en ce qu'au moins une branche active de la première région active se prolonge du côté opposé à la première couche conductrice par un prolongement enterré de même type de conductivité que la première région active et dont l'extrémité libre est reliée à un étage d'entrée de l'entrée E à protéger par l'intermédiaire d'une couche de contact.

**Patentansprüche**

1. Integrierte Schaltung mit einem Halbleiterkörper und mit einer Schutzanordnung gegen elektrostatische Entladungen, wobei der Halbleiterkörper ein Substratgebiet vom ersten Leitungstyp aufweist, die genannte Schutzanordnung ein erstes und ein zweites seitlich beabstandetes aktives in der Nähe des Substratgebietes liegendes Gebiet vom zweiten Leitungstyp hat, wobei das erste aktive Gebiet mit einer ersten zu schützenden leitenden Schicht verbunden ist, während das zweite aktive Gebiet mit einer zweiten leitenden Schicht zur Verbindung mit einer Bezugsspannungsquelle verbunden ist, wobei das erste und zweite aktive Gebiet durch ein durch einen Teil des genannten Substratgebietes gebildetes drittes aktives Gebiet voneinander getrennt sind, wobei eine erste dicke Isolierschicht, die über wenigstens einen Teil ihrer Dicke in dem Halbleiterkörper versenkt ist, und eine zweite dünne Isolierschicht vorhanden sind, wobei die erste Isolierschicht sich in den Halbleiterkörper bis zu einer ersten Tiefe hinein erstreckt und das dritte aktive Gebiet zwischen dem seitlich beabstandeten ersten und zweiten aktiven Gebiet bedeckt, dadurch gekennzeichnet, dass das erste und zweite aktive Gebiet in einer grösseren Tiefe als die genannte erste Tiefe vorgesehen sind und je einen ersten und zweiten Teil aufweisen, wobei jeder der ersten Teile des genannten ersten und zweiten aktiven Gebietes durch ein erstes bzw. zweites Kontaktgebiet vom zweiten Leitungstyp bedeckt ist, wobei das genannte erste und zweite Kontaktgebiet durch die genannte erste bzw. zweite leitende Schicht bedeckt ist und wobei der zweite Teil des ersten und zweiten aktiven Gebietes durch die genannte erste dicke Isolierschicht bedeckt ist.

2. Integrierte Schaltung nach Anspruch 1, dadurch gekennzeichnet, dass das Substratgebiet schwächer dotiert ist als das erste und dritte aktive Gebiet.

3. Integrierte Schaltung nach Anspruch 1 oder 2, dadurch gekennzeichnet, dass das erste und zweite Kontaktgebiet einen Teil einer Epitaxialschicht vom zweiten Leitungstyp bilden.

4. Integrierte Schaltung nach einem der Ansprüche 1 bis 3, dadurch gekennzeichnet, dass das zweite aktive Gebiet das erste aktive Gebiet ringsum umgibt, und dass das zweite Kontaktgebiet das zweite aktive Gebiet ringsum umgibt, mit Ausnahme eines Gebietes, das eine Isolierbrücke bildet, und dass die erste leitende Schicht einen ersten die so gebildete Isolierbrücke überquerenden Kontaktstreifen aufweist zur Bildung einer Verbindung mit einem zu schützenden Eingangskreis.

5. Integrierte Schaltung nach einem der Ansprüche 1 bis 3, dadurch gekennzeichnet, dass die erste leitende Schicht durch eine erste Metallisierungsfläche gebildet ist, dass das zweite aktive Gebiet den Umfang des ersten aktiven Gebietes umgibt; dass das zweite Kontaktgebiet das zweite aktive Gebiet bedeckt mit Ausnahme eines Gebietes, das eine zweite Isolierbrücke bildet und dass die erste leitende Schicht einen zweiten die zweite Brücke überquerenden Kontaktstreifen aufweist zur Bildung einer Verbindung mit einem zu schützenden Eingangskreis.

6. Integrierte Schaltung nach einem der Ansprüche 4 oder 5, dadurch gekennzeichnet, dass die zweite leitende Schicht einen dritten Kontaktstreifen bildet, der derart vorgesehen ist, dass die genannte Verbindung mit einer Bezugsspannungsquelle gebildet wird.

7. Integrierte Schaltung nach einem der Ansprüche 1 bis 3, dadurch gekennzeichnet, dass die erste dicke Isolierschicht durch einen Teil der Isolierschicht gebildet wird, die den Hauptteil der Oberfläche der aktiven Gebiete bedeckt und die selbst durch eine zweite Metallisierungsfläche bedeckt ist, mit Ausnahme eines an die zweite leitende Schicht grenzenden Gebietes, und dass die zweite Metallisierungsfläche einen die erste leitende Schicht bildenden Teil aufweist, derart dass die genannte Fläche mit dem ersten aktiven Gebiet elektrisch verbunden ist.

8. Integrierte Schaltung nach Anspruch 7, dadurch gekennzeichnet, dass das erste aktive Gebiet einerseits 2n-1 aktive Zweige mit n≧1 aufweist und andererseits eine erste elektrische Verbindung, die mit denselben für n>1 ein Ende der genannten 2n-1 aktiven Zweige verbindet und für n=1 durch ein Ende des Zweiges des ersten aktiven Gebietes gebildet ist, dass das zweite aktive Gebiet einerseits 2n aktive Zweige aufweist und andererseits eine zweite elektrische Verbindung, die mit denselben ein Ende der 2n aktiven Zweige verbindet, dass die aktiven Zweige des ersten und zweiten aktiven Gebietes verflochten sind, und dass die erste und zweite elektrische Verbindung derart die erste und zweite leitende Schicht aufweisen, dass die erste leitende Schicht den restlichen Teil der zweiten Metallisierungsfläche begrenzt.

9. Integrierte Schaltung nach Anspruch 8, dadurch gekennzeichnet, dass n=1 ist und dass das zweite aktive Gebiet U-förmig ist, wobei die Schenkel das erste aktive Gebiet einschliessen, und dass die Breite der Schenkel des zweiten aktiven Gebietes der Hälfte der Breite des ersten aktiven Gebietes entspricht.

10. Integrierte Schaltung nach Anspruch 8, dadurch gekennzeichnet, dass n>1 ist und dass die äusseren aktiven Zweige des ersten aktiven Gebietes eine Breite aufweisen, die der Hälfte der Breite seiner anderen aktiven Zweige sowie der Breite der aktiven Zweige des zweiten aktiven Gebietes entspricht.

11. Integrierte Schaltung nach Anspruch 7, dadurch gekennzeichnet, dass das erste aktive Gebiet einerseits 2n-1 aktive Zweige mit n≧1 aufweist und andererseits eine erste elektrische Verbindung, die mit denselben für n>1 ein Ende der genannten 2n-1 aktiven Zweige verbindet und für n=1 durch ein Ende des Zweiges des ersten aktiven Gebietes gebildet ist, dass das zweite aktive Gebiet 2n aktive Zweige aufweist, wobei die aktiven Zweige des ersten und zweiten aktiven Gebietes verflochten sind, dass die 2n aktiven Zweige des zweiten aktiven Gebietes durch die genannte zweite leitende Schicht miteinander elektrisch verbunden sind, und dass wenigstens ein aktiver Zweig des ersten aktiven Gebietes auf der Seite gegenüber der ersten leitenden Schicht durch eine vergrabene Verlängerung von demselben Leitungstyp wie der des ersten aktiven Gebietes verlängert ist und wobei das freie Ende derselben mit Hilfe einer Kontaktschicht mit einer Eingangsstufe des zu schützenden Eingangs E verbunden ist.

## Claims

1. An integrated circuit having a semiconductor body and comprising a device for protection against electrostatic discharges, the said semiconductor body having a substrate region of a first conductivity type, the said protection device having a first and a second active region of a second conductivity type which are laterally spaced and which adjoin said substrate region, the first active region being connected to a first conductive layer to be protected, the second active region being connected to a second conductive layer for connection to a reference voltage source, the first and second active regions being separated by a third active region which is formed by a portion of the said substrate region, a first thick insulating layer which over at least part of its thickness is inset in the semiconductor body and a second thin insulating layer being present, the said first insulating layer extending into the semiconductor body to a first depth and covering the said third active region between the said laterally spaced first and second active regions, characterized in that the first and second active regions are present in the semiconductor body at a larger depth than the said first depth and each have a first and a second portion, each of the first portions of the said first and second active regions being covered by a first and a second contact region, respectively, of the second conductivity type, the said first and second contact regions being covered by the said first and second conductive layers, respectively, and the second portions of the first and second active regions being covered by the said first thick insulating layer.

2. An integrated circuit as claimed in Claim 1, charcterized in that the substrate region is more weakly doped than the first and second active region.

3. An integrated circuit as claimed in Claim 1 or Claim 2, charcterized in that the first and second contact regions form part of an epitaxial layer of the second conductivity type.

4. An integrated circuit as claimed in any one of Claims 1 to 3, characterized in that the second active region completely surrounds the first active region, in that the second contact region surrounds the first active region but for a region forming an insulating bridge, and in that the first conductive layer has a first contact strip passing over the insulating bridge thus formed so that it forms a connection with an input circuit to be protected.

5. An integrated circuit as claimed in any one of Claims 1 to 3, characterized in that the first conductive layer comprise a first metallization layer, in that the second active region surrounds the periphery of the first active region, in that the second contact region covers the second active region but for a region forming a second insulating bridge, and in that the first conductive layer has a second contact strip passing over the second insulating bridge so that it forms a connection with an input circuit to be protected.

6. An integrated circuit as claimed in any one of Claims 4 or 5, characterized in that the second conductive layer has a third contact strip arranged for the purpose of establishing the said connection to a reference voltage source.

7. An integrated circuit as claimed in any one of Claims 1 to 3, characterized in that the first thick insulating layer is constituted by a portion of the insulating layer covering the major part of the surface of the active regions and itself being covered by a second metallization layer but for a region adjoining the second conductive layer, and in that the said second metallization layer comprises a first part forming said first conductive layer which electrically connects the said second metallization layer to the first active region.

8. An integrated circuit as claimed in Claim 7, characterized in that the first active region has on the one hand 2n-1 active branches with n≧1 and on the other hand a first electrical connection portion interconnecting for n>1 ends of the said 2n-1 active branches and constituted for n=1 by an end of the branch of the first active region, in that the second active region has on the one hand 2n active branches and on the other hand a second electrical connection portion interconnecting ends of the 2n active branches, in that the active branches of the first and the second active regions are arranged interdigitally, and in that the second electrical connection portions comprise the first and second conductive layers in such a manner that the first conductive layer bounds the remaining part of the second metallization layer.

9. An integrated circuit as claimed in Claim 8, characterized in that n=1 and in that the second active region has the form of a U, whose branches enclose the first active region, and in that the width of the branches of the second active region is equal to half that of the first active region.

10. An integrated circuit as claimed in Claim 8, characterized in that n>1 and in that the outer active branches of the second active region have a width equal to half that of its other active branches and of that of the first active region.

11. An integrated circuit as claimed in Claim 7, characterized in that the first active region has on the one hand 2n-1 active branches with n≧1 and on the other hand a first electrical connection portion interconnecting for n>1 ends of the said 2n-1 active branches and constituted for n=1 by an end of the branch of the first active region, in that the second active region has 2n active branches, the active branches of the first and second active regions being arranged interdigitally, in that the 2n active branches of the second active region are electrically interconnected by the said second conductive layer, and in that at least one active branch of the first active region is prolonged on a side opposite to the side at which the first conductive layer is located by a prolonged buried part of the same conductivity type as the first active region and whose free end is connected to an input stage of the input (E) to be protected with the aid of a contact region.

FIG.1a

FIG.1b

FIG.2

FIG.3

FIG.4a

FIG.4b

FIG.5

FIG.6

FIG.7

FIG.8a

FIG.8b

FIG.9a

FIG.10

FIG.9b

313    301
300  308  | 307  306  | 305  311  304  312  310  300

**FIG.11**

302          303  1  302